# EUROPEAN PATENT APPLICATION

(11) **EP 4 760 723 A1**
(43) Date of publication of application: **17.06.2026**
(21) Application number: 25185235.6
(22) Date of filing: 25.06.2025
(51) Int. Cl.: G11C 29/02

(54) **TEST CIRCUIT AND MEMORY DEVICE INCLUDING THEREOF, AND OPERATION METHOD OF MEMORY DEVICE**

(30) Priority: 13.12.2024 KR 20240186061
(71) Applicant: Samsung Electronics Co., Ltd., Suwon-si, Gyeonggi-do 16677 (KR)
(72) Inventor: LEE, Jisoo, 16677 Suwon-si, Gyeonggi-do (KR)
(74) Representative: Kuhnen & Wacker Patent- und Rechtsanwaltsbüro PartG mbB

(57) **Abstract**

A test circuit (TC) connected to a program wordline (WL_PGM) and a read wordline (WL_RD) of an anti-fuse memory device is provided. The test circuit (TC) includes: a first pulling circuit (PC1) connected to a first pulling node (NP1), wherein the first pulling circuit (PC1) is configured to electrically float the first pulling node (NP1) based on a mode selection signal (MDS); a first test transistor (TTR1) connected between the first pulling node (NP1) and a middle node (NM), wherein a first gate terminal of the first test transistor (TTR1) is connected to the program wordline (WL_PGM); a second test transistor (TTR2) connected between the middle node (NM) and a second pulling node (NP2), wherein a second gate terminal of the second test transistor (TTR2) is connected to the read wordline (WL_RD); and a second pulling circuit (PC2) connected to the second pulling node (NP2).

## Description

### BACKGROUND

### 1. Field

The present disclosure relates to a test circuit testing a row decoder of an anti-fuse memory device. More specifically, the present disclosure relates to a test circuit and a memory device including thereof in which unintended gate oxide breakdown due to a program operation is prevented.

### 2. Description of the Related Art

An anti-fuse memory device may store data based on the oxide breakdown phenomenon of transistors. More specifically, the anti-fuse memory device may include a plurality of anti-fuse memory cells. Each of the plurality of anti-fuse memory cells may include a cell transistor having a gate terminal connected to a program wordline. Each of the plurality of anti-fuse memory cells may store data based on whether the gate oxide layer of the cell transistor is in a breakdown state.

The test circuit may test whether the row decoder of an anti-fuse memory device successfully provides appropriate voltage levels to the wordlines. For example, the test circuit may test the voltage level of a program wordline based on a test transistor having a gate terminal connected to the program wordline.

In order to break down the oxide layer of the cell transistor, a high voltage level (e.g., program voltage) should be provided to the program wordline. However, in this case, the gate oxide of the test transistor may also be broken down due to the program voltage. Accordingly, the test accuracy of the test circuit may be deteriorated.

### SUMMARY

One or more embodiments solve the technical problems described above. More specifically, one or more embodiments provide a test circuit in which a gate oxide breakdown phenomenon of the test transistor is prevented, and a memory device including thereof.

According to an aspect of an embodiment, a test circuit is connected to a program wordline and a read wordline of an anti-fuse memory device. The test circuit includes: a first pulling circuit connected to a first pulling node, wherein the first pulling circuit is configured to electrically float the first pulling node based on a mode selection signal; a first test transistor connected between the first pulling node and a middle node, wherein a first gate terminal of the first test transistor is connected to the program wordline; a second test transistor connected between the middle node and a second pulling node, wherein a second gate terminal of the second test transistor is connected to the read wordline; and a second pulling circuit connected to the second pulling node.

According to another aspect of an embodiment, a memory device includes: a row decoder configured to control a first program wordline and a first read wordline; a memory cell array including a first anti-fuse memory cell row which is connected to the first program wordline and the first read wordline; and a test circuit including: a first test transistor including a first gate terminal connected to the first program wordline; and a second test transistor including a second gate terminal connected to the first read wordline. The test circuit is configured to float a channel of the first test transistor during a first time period and a program operation is performed on the first anti-fuse memory cell row during the first time period.

According to another aspect of an embodiment, an operation method of a memory device including a plurality of anti-fuse memory cells connected to a first program wordline, is provided. The operation method includes: floating a channel of a first test transistor connected between a first node and a second node, wherein a first gate terminal of the first test transistor is connected to the first program wordline; and providing a program voltage to the first program wordline.

### BRIEF DESCRIPTION OF DRAWINGS

The above and other aspects and features will be more apparent from the following description of example embodiments with reference to the attached drawings, in which:
FIG. 1 is a block diagram showing a memory device according to an embodiment.
FIG. 2 is a drawing showing configurations of a memory device according to an embodiment.
FIG. 3 is a drawing showing a test circuit while operating in test mode according to an embodiment.
FIG. 4 is a diagram showing a program operation for one memory cell row according to an embodiment.
FIG. 5 is a diagram showing a read operation for one memory cell row according to an embodiment.
FIG. 7 is a diagram showing a test circuit operating in a program protection mode according to an embodiment.
FIG. 8 is a drawing showing a detailed configuration of a test circuit according to an embodiment.
FIG. 9 is a timing diagram showing a program protection operation according to an embodiment.
FIG. 10 is a flowchart showing an operation method of a memory device according to an embodiment.
FIG. 11 is a drawing showing operation S110 of FIG. 10 in more detail according to an embodiment.
FIG. 12 is a drawing showing a portion of a memory device according to an embodiment.
FIG. 13 is a block diagram showing configuration of a test circuit array according to an embodiment.
FIG. 14 is a drawing showing configuration of a test circuit according to an embodiment.

### DETAILED DESCRIPTION

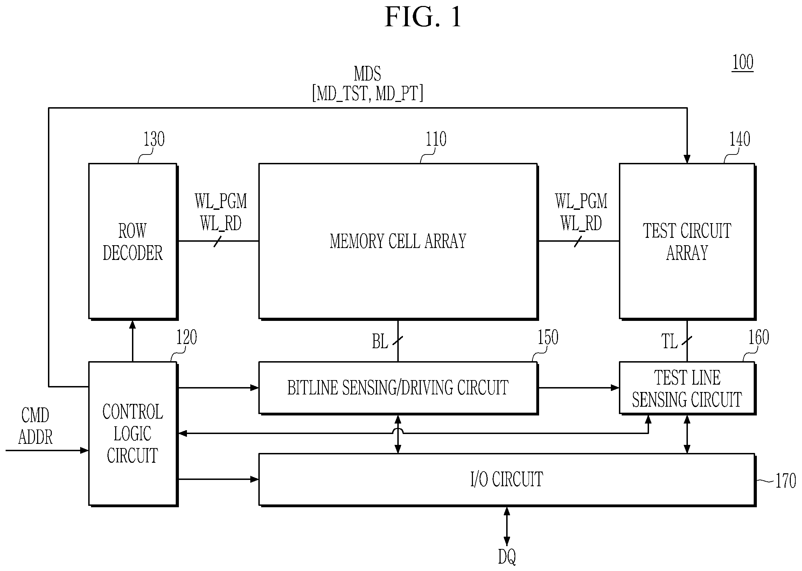

FIG. 1 is a block diagram showing a memory device according to an embodiment. Referring to FIG. 1, the memory device 100 may include a memory cell array 110, a control logic circuit 120, a row decoder (e.g., row decoder circuit) 130, a test circuit array 140, a bitline sensing/driving circuit 150, a test line sensing circuit 160, and an input/output circuit 170.

The memory cell array 110 may include a plurality of memory cells. The plurality of memory cells may be connected to a plurality of program wordlines WL_PGM and a plurality of read wordlines WL_RD extending in a row direction. The plurality of memory cells may be connected to a plurality of bitlines BL extending in a column direction.

In an embodiment, each of the plurality of memory cells included in the memory cell array 110 may be an anti-fuse memory cell. For example, each of the plurality of memory cells included in the memory cell array 110 may be implemented to store '0' or '1' based on whether the gate oxide layer of transistor is broken down. Accordingly, the memory device 100 may be referred to as an anti-fuse memory device, and the memory cell array 110 may be referred to as an anti-fuse memory cell array.

The control logic circuit 120 may control overall operations of the memory device 100 based on command CMD and address ADDR provided from outside (e.g., external device). For example, the control logic circuit 120 may control operation of the row decoder 130, the bitline sensing/driving circuit 150, the test line sensing circuit 160, and the input/output circuit 170 based on the command CMD and the address ADDR.

The row decoder 130 may control a plurality of program wordlines WL_PGM and a plurality of read wordlines WL_RD based on the address ADDR. When the memory device 100 performs a program operation for the memory cell array 110, the row decoder 130 may provide a program voltage (hereinafter, it may be referred to as "VPGM") to one of the plurality of program wordlines WL_PGM and may provide a pass voltage (hereinafter, it may be referred to as "VPASS") to one of the plurality of read wordlines WL_RD. When the memory device 100 performs a read operation on the memory cell array 110, the row decoder 130 may provide the pass voltage VPASS to one of the plurality of program wordlines WL_PGM and one of the plurality of read wordlines WL_RD.

In an embodiment, the program voltage VPGM may be a voltage level sufficiently high enough to break down a gate oxide of a transistor (i.e., high enough to cause gate oxide breakdown phenomenon). For example, the program voltage may be about 4.2 V. However, embodiments are not limited thereto.

In an embodiment, the pass voltage VPASS may be a voltage level high enough to turn on transistor, but lower than the program voltage. For example, the pass voltage VPASS may be about 0.9 V or about 1.2 V. However, embodiments are not limited thereto.

The test circuit array 140 may include a plurality of test circuits. The plurality of test circuits may be connected to the plurality of program wordlines WL_PGM, the plurality of read wordlines WL_RD, and a plurality of test lines TL.

That is, the memory cell array 110 and the test circuit array 140 may be connected to same wordlines. For example, the memory cell array 110 and the test circuit array 140 may share the plurality of program wordlines WL_PGM and the plurality of read wordlines WL_RD.

The test circuit array 140 may test whether the row decoder 130 operates normally. That is, the test circuit array 140 may test whether the voltage levels of the plurality of program wordlines WL_PGM and the plurality of read wordlines WL_RD are appropriately changed according to the control of the control logic circuit 120. More specifically, the test circuit array 140 may control voltage levels of the plurality of test lines TL based on voltage levels of the plurality of program wordlines WL_PGM and the plurality of read wordlines WL_RD. In this case, the voltage levels of the plurality of test lines TL may be determined according to whether the row decoder 130 operates normally.

While a program operation is performed on the memory cell array 110, the program voltage VPGM may be applied to one of the plurality of program wordlines WL_PGM. As the test circuit array 140 is connected to the plurality of program wordlines WL_PGM, a gate oxide layer of a transistor included in the test circuit array 140 may be broken down unintentionally during the program operation. In this case, after the gate oxide layer is broken down, it may become difficult for the test circuit array 140 to successfully test whether the row decoder 130 operates normally.

According to an embodiment, the control logic circuit 120 may generate a mode selection signal MDS. The mode selection signal MDS may indicate a test mode MD_TST or a program protection mode MD_PT.

The control logic circuit 120 may set the mode selection signal MDS to indicate the test mode MD_TST while performing the test operation for the row decoder 130. In this case, as described above, the test circuit array 140 may control the voltage levels of the plurality of test lines TL based on the voltage levels of the plurality of program wordlines WL_PGM and the plurality of read wordlines WL_RD.

The control logic circuit 120 may set the mode selection signal MDS to indicate the program protection mode MD_PT prior to performing the program operation on the memory cell array 110. In this case, the test circuit array 140 may perform a program protection operation. For example, before the program voltage VPGM is applied to a specific program wordline WL_PGM, to prevent gate oxide layer breakdown of a transistor of the test circuit array 140, the test circuit array 140 may float a channel of the transistor connected to the specific program wordline WL_PGM. In this case, even if the program voltage VPGM is applied to the gate terminal of the transistor, breakdown of the gate oxide layer of the transistor may be prevented in a self-boost scheme.

For a more concise explanation, FIG. 1 is representatively illustrated as an embodiment in which a memory cell array 110 is arranged between the row decoder 130 and the test circuit array 140, but embodiments are not limited thereto. For example, according to an embodiment, the test circuit array 140 may be located between the row decoder 130 and the memory cell array 110, or the row decoder 130 may be disposed between the test circuit array 140 and the memory cell array 110. That is, embodiments are not limited to the specific arrangement method of the row decoder 130, the test circuit array 140, and the memory cell array 110.

The bitline sensing/driving circuit 150 may be connected to a plurality of bitlines BL. The bitline sensing/driving circuit 150 may provide voltage to the plurality of bitlines BL or may detect current flowing in the plurality of bitlines BL (or detect voltage levels of the plurality of bitlines BL), based on the control of the control logic circuit 120.

The test line sensing circuit 160 may be connected to a plurality of test lines TL. The test line sensing circuit 160 may detect the voltage levels of the plurality of test lines TL.

The test line sensing circuit 160 may provide a test value corresponding to the voltage level of the test line TL to the control logic circuit 120. In this case, the control logic circuit 120 may be able to recognize whether the row decoder 130 successfully controls the wordlines WL based on the test value.

In an embodiment, the control logic circuit 120 may control the bitline sensing/driving circuit 150 based on the test value. For example, the control logic circuit 120 may further perform test operations related to the plurality of bitlines BL by controlling the plurality of bitlines BL based on the test values. However, embodiments are not limited thereto.

In an embodiment, the test line sensing circuit 160 may provide a test value corresponding to the voltage level of the test line TL to the input/output circuit 170. That is, embodiments are not limited to the specific manner how the test value generated from the test line sensing circuit 160 are utilized.

The input/output circuit 170 may receive data from an external device or transmit data to the external device through one or more data pins DQ. For example, the input/output circuit 170 may provide data received from the external device to the bitline sensing/driving circuit 150, or output data corresponding to current flowing in a plurality of bitlines BL (or voltage levels of a plurality of bitlines BL) provided from the bitline sensing/driving circuit 150 to the external device.

In an embodiment, the input/output circuit 170 may output test values provided from the test line sensing circuit 160 to an external device via one or more data pins DQ. However, embodiments are not limited thereto.

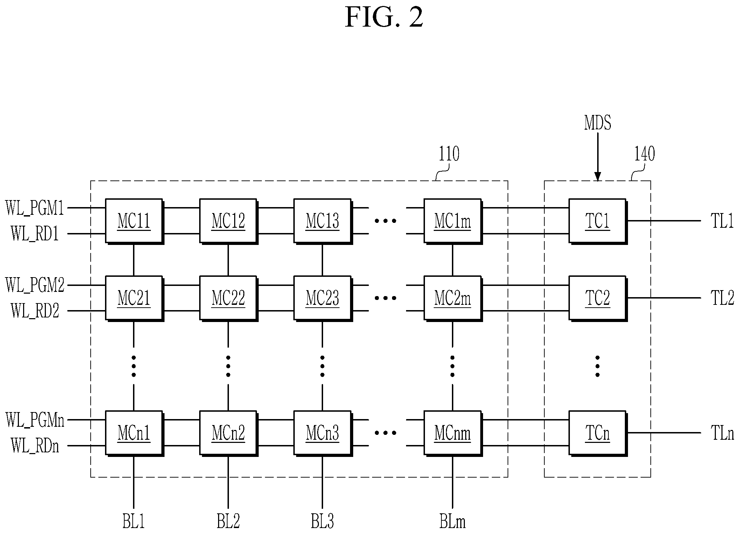

FIG. 2 is a drawing showing some of the configurations of FIG. 1 in more detail. Referring to FIGS. 1 and 2, the memory cell array 110 may include a plurality of memory cells MC. The plurality of memory cells MC may be arranged in the row and column directions to form a matrix structure.

The plurality of memory cells MC may be connected to first to n-th program wordlines WL_PGM1 to WL_PGMn and first to n-th read wordlines WL_RD1 to WL_RDn. The plurality of memory cells MC may be connected to the first to m-th bitlines BL1 to BLm. The memory cell connected to the i-th program wordline, the i-th read wordline, and the j-th bitline may be referred to as a memory cell MCij. For example, a memory cell connected to the second program wordline WL_PGM2, the second read wordline WL_RD2, and the first bitline BL1 may be referred to as a memory cell MC21.

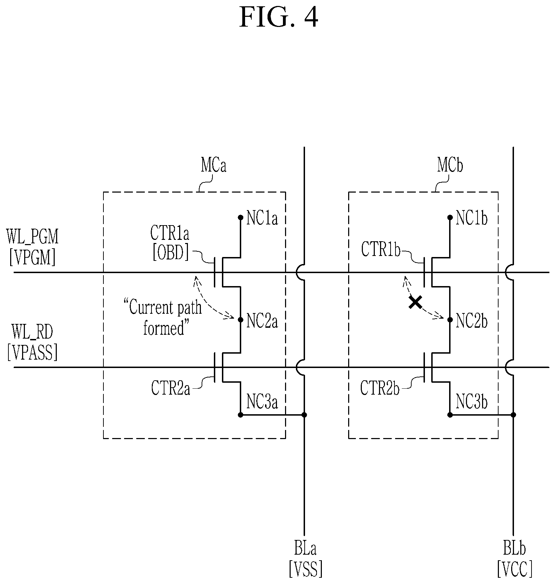

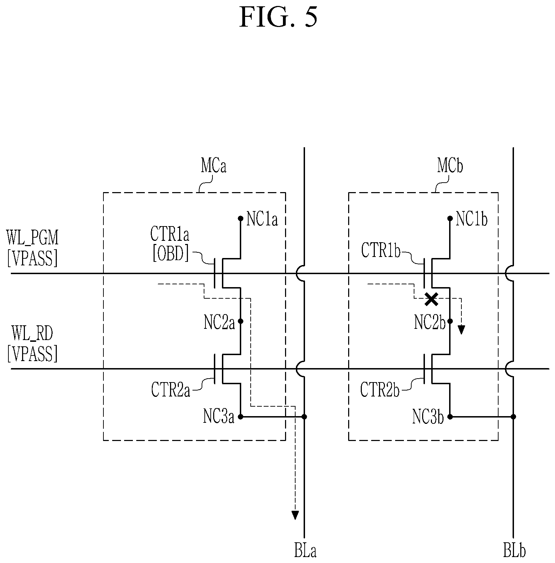

Each of the plurality of memory cells MC may include an anti-fuse transistor. Each of the plurality of memory cells MC may store data based on whether the gate oxide breakdown has occurred on the anti-fuse transistor. For example, each of the plurality of memory cells MC may store data based on whether a gate oxide layer of the anti-fuse transistor has broken down. A more detailed configuration of the plurality of memory cells MC is described in more detail with reference to FIGS. 4 and 5 below.

The test circuit array 140 may include first to n-th test circuits TC1 to TCn. The first to n-th test circuits TC1 to TCn may be connected to the first to n-th program wordlines WL_PGM1 to WL_PGMn, the first to n-th read wordlines WL_RD1 to WL_RDn, and the first to n-th test lines TL1 to TLn, respectively.

That is, each of the plurality of memory cells MC and the plurality of test circuits TC may be connected to a pair of wordlines WL. More specifically, each of the plurality of memory cells MC and each of the plurality of test circuits TC may be connected to one program wordline WL_PGM and one read wordline WL_RD.

Memory cells MC connected to the same wordline pair may be referred to as a memory cell row. For example, memory cells MC11 to MC1m may be referred to as a first memory cell row, and memory cells MC21 to MC2m may be referred to as a second memory cell row.

In an embodiment, each of the plurality of memory cells MC may be implemented as an anti-fuse memory cell. In this case, each of the plurality of memory cell rows included in the memory cell array 110 may be referred to as an anti-fuse memory cell row.

The memory cell array 110 may be programmed or read in unit of memory cell row. For example, the control logic circuit 120 may perform the program operation or the read operation for a pair of program wordline WL_PGM and read wordline WL_RD, by controlling the row decoder 130 and the bitline sensing/driving circuit 150. The program operation for one memory cell row is described in more detail with reference to FIG. 4 below, and the read operation for one memory cell row is described in more detail with reference to FIG. 5 below.

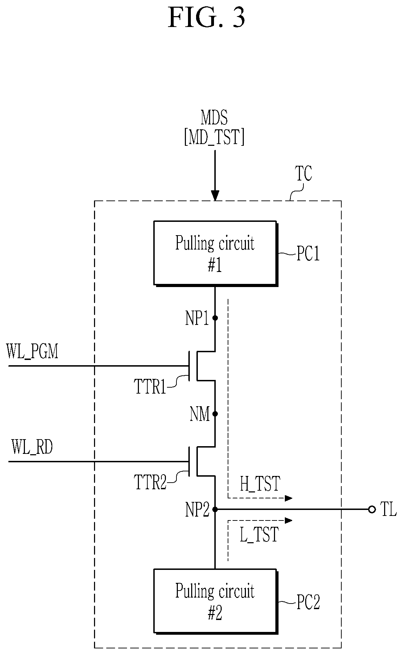

In response to the mode selection signal MDS indicating the test mode MD_TST, each of the plurality of test circuits TC may control the voltage level of the test line TL based on voltage levels of a program wordline WL_PGM and a read wordline WL_RD. For example, the first test circuit TC1 may control the voltage level of the first test line TL1 based on the voltage levels of the first program wordline WL_PGM1 and the first read wordline WL_RD1. In this case, based on the voltage level of the first test line TL1, it may be identified whether the row decoder 130 has appropriately set the voltage levels of the first program wordline WL_PGM1 and the first read wordline WL_RD1 to the intended voltage levels. The manner in which the test circuit TC determines the voltage level of the test line TL is described in more detail with reference to FIG. 3 below.

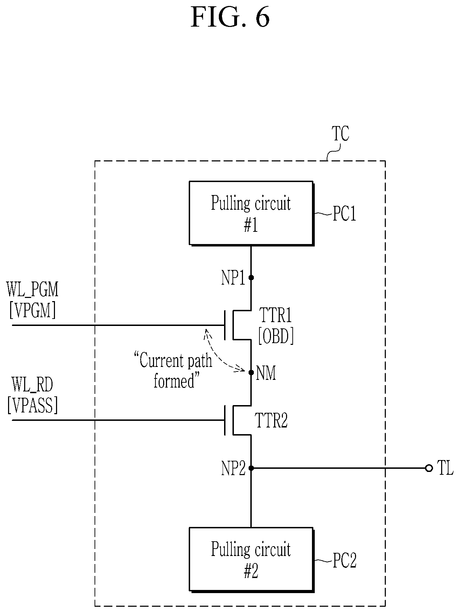

In response to the mode selection signal MDS indicating the program protection mode MD_PT, each of the plurality of test circuits TC may perform the program protection operation. More specifically, each of the plurality of test circuits TC may perform the program protection operation before the program operation is performed on a memory cell row which shares a program wordline WL_PGM and a read wordline WL_RD. For example, the first test circuit TC1 may perform the program protection operation, before the program operation being performed on memory cells MC11 to MC1m included in the first memory cell row (i.e., before the voltage level of the first program wordline WL_PGM1 rises to the program voltage VPGM). The program protection operations performed by the test circuit TC are described in more detail with reference to FIG. 6 below.

FIG. 3 is a drawing showing a test circuit, such as a test circuit of FIG. 2, while operating in test mode. Hereinafter, with reference to FIGS. 1 to 3, an example in which one of the first to n-th test circuits TC1 to TCn operates in the test mode MD_TST will be representatively described. That is, hereinafter, it is assumed that the mode selection signal MDS indicating the test mode MD_TST is provided to the test circuit TC.

The test circuit TC may be connected to one program wordline WL_PGM and one read wordline WL_RD.

The test circuit TC may include a first pulling circuit PC1, a second pulling circuit PC2, a first test transistor TTR1, and a second test transistor TTR2.

The first pulling circuit PC1 may be connected to the first pulling node NP1. The first pulling circuit PC1 may provide a test logic high voltage H_TST to the first pulling node NP1.

The second pulling circuit PC2 may be connected to the second pulling node NP2. The second pulling circuit PC2 may provide a test logic low voltage L_TST to the second pulling node NP2.

In an embodiment, the test logic high voltage H_TST may be a bias voltage, or a voltage level corresponding to the bias voltage. The test logic low voltage L_TST may be a ground voltage or a voltage level corresponding to ground voltage. However, embodiments are not limited to specific voltage levels of test logic low voltage L_TST and test logic high voltage H_TST.

The first test transistor TTR1 may be connected between the first pulling node NP1 and the middle node NM. A gate terminal of the first test transistor TTR1 may be connected to the program wordline WL_PGM. The first test transistor TTR1 may be turned on when the voltage level of the program wordline WL_PGM is logic high, and may be turned off when the voltage level of the program wordline WL_PGM is logic low.

In an embodiment, the first test transistor TTR1 may be referred to as a 'program test transistor'. However, embodiments are not limited to these terms.

A second test transistor TTR2 may be connected between the middle node NM and the second pulling node NP2. A gate terminal of the second test transistor TTR2 may be connected to the read wordline WL_RD. The second test transistor TTR2 may be turned on when the voltage level of the read wordline WL_RD is logic high, and may be turned off when the voltage level of the read wordline WL_RD is logic low.

In an embodiment, the second test transistor TTR2 may be referred to as a 'read test transistor'. However, embodiments are not limited to these terms.

The test line TL may be connected to the second pulling node NP2. The voltage level of the test line TL may be determined according to the voltage level of the second pulling node NP2. For example, the voltage level of the test line TL may be determined depending on whether a test logic high voltage H_TST and/or a test logic low voltage L_TST is provided to the second pulling node NP2. However, embodiments are not limited thereto. For example, the test line TL may be connected to a node other than the second pulling node NP2, for example, the first pulling node NP1.

The control logic circuit 120 may test whether the row decoder 130 may normally provide a logic high voltage to the program wordline WL_PGM and the read wordline WL_RD. For example, the control logic circuit 120 may control the row decoder 130 to provide a logic high voltage to each of the program wordline WL_PGM and the read wordline WL_RD. In this case, if the row decoder 130 operates successfully under the control of the control logic circuit 120, the first test transistor TTR1 and the second test transistor TTR2 may be turned on. In this case, the test logic high voltage H_TST output from the first pulling circuit PC1 may be provided to the test line TL through the first test transistor TTR1 and the second test transistor TTR2. That is, when the row decoder 130 generates the logic high voltages successfully, the voltage level of the test line TL may be the test logic high voltage H_TST.

The control logic circuit 120 may test whether the row decoder 130 successfully provides logic low to the program wordline WL_PGM and the read wordline WL_RD. For example, the control logic circuit 120 may control the row decoder 130 to provide the logic low voltage to the program wordline WL_PGM and the read wordline WL_RD. In this case, if the row decoder 130 operates successfully under the control of the control logic circuit 120, the first test transistor TTR1 and the second test transistor TTR2 may be turned off. In this case, the test logic high voltage H_TST output from the first pulling circuit PC1 may not be provided to the test line TL. Therefore, when the row decoder 130 successfully generates the logic low voltage, the voltage level of the test line TL may be the test logic low voltage L_TST.

FIG. 4 is a diagram showing a program operation for one memory cell row. Referring to FIGS. 1, 2, and 4, a control logic circuit 120 may perform a program operation on one memory cell row (hereinafter, it may be referred to as a 'program target memory cell row') including a first memory cell MCa and a second memory cell MCb. For example, the control logic circuit 120 may provide the program voltage VPGM to a program wordline WL_PGM connected to a 'program target memory cell row' (e.g., for a predetermined time length) and may provide the pass voltage VPASS to a read wordline WL_RD connected to the 'program target memory cell row'. The voltage level of the program voltage VPGM may be higher than the voltage level of the pass voltage VPASS.

The control logic circuit 120 may program some of the memory cells included in one memory cell row in response to the command CMD and address ADDR. In this regard, the control logic circuit 120 may determine some memory cells included in one memory cell row as program target memory cells, and may determine the remaining memory cells included in the memory cell row as program inhibit memory cells. For a more concise explanation, hereinafter, it is assumed that the first memory cell MCa is a program target memory cell and the second memory cell MCb is a program inhibit memory cell.

The control logic circuit 120 may control the bitline sensing/driving circuit 150 to provide the ground voltage VSS to a first bitline BLa connected to a first memory cell MCa and to provide a power supply voltage VCC to a second bitline BLb connected to a second memory cell MCb. That is, different voltages may be provided to the bitline connected to the program target memory cell and the bitline connected to the program inhibit memory cell.

The first memory cell MCa may include a first cell transistor CTR1a and a second cell transistor CTR2a. The first cell transistor CTR1a may be connected between a first cell node NC1a and a second cell node NC2a, and the second cell transistor CTR2a may be connected between a second cell node NC2a and a third cell node NC3a. The first cell node NC1a may be floated, and the third cell node NC3a may be connected to the first bitline BLa.

A gate terminal of the first cell transistor CTR1a may be connected to a program wordline WL_PGM. A gate terminal of the second cell transistor CTR2a may be connected to the read wordline WL_RD.

The second cell transistor CTR2a may be turned on based on the voltage level of the read wordline WL_RD (i.e., the pass voltage VPASS). In this case, the voltage level of the second cell node NC2a may be determined based on the voltage level of the first bitline BLa (e.g., ground voltage VSS).

The first cell transistor CTR1a may be programmed based on the difference between a gate voltage level (e.g., program voltage VPGM) and a channel voltage level (e.g., ground voltage VSS). For example, if the voltage level difference between the gate and channel of the first cell transistor CTR1a is sufficiently large (i.e., if the strength of the electric field applied to the gate oxide layer of the first cell transistor CTR1a is sufficiently large), the gate oxide layer of the first cell transistor CTR1a may be broken down. That is, due to the difference in voltage level of the program wordline WL_PGM and the voltage level of the second cell node NC2a, the gate oxide layer of the first cell transistor CTR1a may be broken, and the first cell transistor CTR1a may become oxide breakdown (OBD) state. In this case, a current path may be formed from the program wordline WL_PGM to the second cell node NC2a.

In contrast, the second memory cell MCb may include a first cell transistor CTR1b and a second cell transistor CTR2b. The first cell transistor CTR1b may be connected between a first cell node NC1b and a second cell node NC2b, and a second cell transistor CTR2b may be connected between a second cell node NC2b and a third cell node NC3b. The first cell node NC1b may be floated, and the third cell node NC3b may be connected to the second bitline BLb.

A gate terminal of the first cell transistor CTR1b may be connected to the program wordline WL_PGM. A gate terminal of the second cell transistor CTR2b may be connected to the read wordline WL_RD.

The second cell transistor CTR2b may be turned on based on the voltage level of the read wordline WL_RD (i.e., the pass voltage VPASS). In this case, the voltage level of the second cell node NC2b may be determined based on the voltage level of the second bitline BLb (e.g., the power supply voltage VCC).

The first cell transistor CTR1b may be turned on based on the voltage level of the program wordline WL_PGM (e.g., the program voltage VPGM). However, the first cell transistor CTR1b may be program-inhibited based on the difference between the gate voltage level (e.g., the voltage level of the program wordline WL_PGM) and the channel voltage level (e.g., the voltage level of the second cell node NC2b). For example, if the potential difference between the gate and the channel of the first cell transistor CTR1b is not sufficiently large (i.e., if the strength of the electric field applied to the gate oxide layer of the first cell transistor CTR1b is not sufficiently large), the gate oxide layer of the first cell transistor CTR1b may not be broken down. That is, due to the voltage level difference between the program voltage VPGM and the power supply voltage VCC, the gate oxide layer of the first cell transistor CTR1b may not be broken down. In this case, a current path from the program wordline WL_PGM to the second cell node NC2b may not be formed.

In an embodiment, programmed memory cells (i.e., memory cells including a transistor whose gate oxide has been broken down) may store a '1'. Unprogrammed memory cells (i.e., memory cells including a transistor whose gate oxide has not been broken down) may store '0'. However, embodiments are not limited thereto.

For a more concise explanation, FIG. 4 is representatively described as an representative embodiment in which the ground voltage VSS is provided to a bitline connected to a program target memory cell, and a power supply voltage VCC is provided to a bitline connected to a program inhibit memory cell; however, embodiments are not limited to the level of specific voltages provided to each bitline.

In an embodiment, a voltage provided to a bitline connected to a program target memory cell may be referred to as a 'program bitline voltage', and a voltage provided to a bitline connected to a program inhibit memory cell may be referred to as an 'inhibit bitline voltage'. However, embodiments are not limited thereto.

In an embodiment, the first cell transistor CTR1a and the first cell transistor CTR1b may be referred to as anti-fuse transistors. However, embodiments are not limited thereto.

FIG. 5 is a diagram showing a read operation for the memory cells of FIG. 4. Referring to FIGS. 1, 2, and 4 to 5, the control logic circuit 120 may perform a read operation on one memory cell row (hereinafter, referred to as a 'read target memory cell row') including the first memory cell MCa and the second memory cell MCb. For example, the control logic circuit 120 may control the row decoder 130 to provide the pass voltage VPASS to the program wordline WL_PGM and the read wordline WL_RD, which are connected to the read target memory cell row.

For a more concise explanation, it is assumed below that the row decoder 130 provides the pass voltage VPASS to both the program wordline WL_PGM and the read wordline WL_RD. However, embodiments are not limited thereto. For example, while performing the read operation on the read target memory cell row, the row decoder 130 may also be configured to provide the relatively higher voltage to the program wordline WL_PGM than to the read wordline WL_RD.

First, referring to the first memory cell MCa, the first cell transistor CTR1a may be in an oxide breakdown (OBD) state in the manner described above with reference to FIG. 4. In this case, current may flow from the program wordline WL_PGM to the first bitline BLa through the second cell node NC2a and the third cell node NC3a. The bitline sensing/driving circuit 150 may recognize that the first memory cell MCa is in a programmed state (e.g., a state storing '1') by detecting the magnitude of the current (or voltage change) flowing into the first bitline BLa.

On the other hand, as described above with reference to FIG. 4, with reference to the second memory cell MCb, the first cell transistor CTR1b may be not in OBD state. In this case, current may not flow from the program wordline WL_PGM to the second bitline BLb. The bitline sensing/driving circuit 150 may recognize that the second memory cell MCb is in an unprogrammed state (e.g., a state storing '0') based on that there is no current flows in the second bitline BLb (or, no voltage change occurs in the second bitline BLb).

FIG. 6 is a drawing showing a gate oxide breakdown phenomenon of a test transistor caused by a program operation on a memory cell.

Referring to FIGS. 1 to 6, the test circuit TC may share the program wordline WL_PGM and the read wordline WL_RD with the program target memory cell row described above with reference to FIG. 4. In this case, as the program operation is performed for the program target memory cell row, the voltage level of the program wordline WL_PGM connected to the test circuit TC may rise to the program voltage VPGM.

When the program wordline WL_PGM rises to the program voltage VPGM, the first test transistor TTR1 may be unintentionally programmed, similar to what was described above with reference to FIG. 4. For example, due to a difference between the gate voltage level and the channel voltage level of the first test transistor TTR1, the gate oxide layer of the first test transistor TTR1 may be broken down.

If the gate oxide layer of the first test transistor TTR1 is broken down, a current path may be formed between the program wordline WL_PGM and the middle node NM. In this case, an error may occur in the test operation of the test circuit TC. For example, an error may occur in the voltage level of the test line TL determined by the test circuit TC due to a current path unintentionally formed between the program wordline WL_PGM and the middle node NM. Hereinafter, a scheme for preventing the gate oxide breakdown of the first test transistor TTR1 due to the program voltage VPGM will be described.

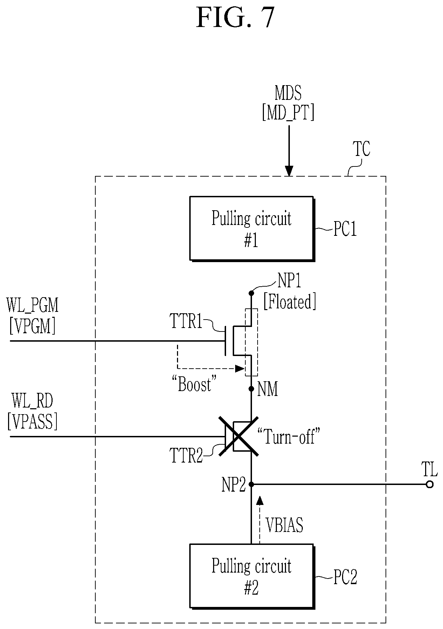

FIG. 7 is a diagram showing the test circuit of FIG. 2 operating in program protection mode in more detail. Hereinafter, with reference to FIGS. 1 to 7, an example in which one of the first to n-th test circuits TC1 to TCn operates in a program protection mode MD_PT will be described. That is, hereinafter, it is assumed that a mode selection signal MDS indicating a program protection mode MD_PT is provided to the test circuit TC.

The test circuit TC may perform program protection operation with a self-boost scheme. Hereinafter, a specific manner how the test circuit TC performs program protection operation with the self-boost scheme is described.

In response to a mode selection signal MDS indicating the program protection mode MD_PT, the first pulling circuit PC1 may electrically float the first pulling node NP1. For example, the first pulling circuit PC1 may not provide voltage (e.g., a bias voltage or a ground voltage, etc.) to the first pulling node NP1. For example, the first pulling circuit PC1 may electrically open a connection between a voltage (e.g., a bias voltage or a ground voltage, etc.) and the first pulling node NP1.

In response to the mode selection signal MDS indicating the program protection mode MD_PT, the second pulling circuit PC2 may electrically float the middle node NM by turning off the second test transistor TTR2. For example, the second pulling circuit PC2 may provide a bias voltage VBIAS to the second pulling node NP2. In this case, the difference between the voltage level of the gate terminal of the second test transistor TTR2 (e.g., the pass voltage VPASS) and the voltage level of the source terminal (e.g., the bias voltage VBIAS) may be smaller than a threshold voltage of the second test transistor TTR2. In this case, the second test transistor TTR2 may be turned off and the middle node NM may also be electrically floated.

In this way, the channel of the first test transistor TTR1 (more specifically, the first pulling node NP1 and the middle node NM) may be floated before the voltage level of the program wordline WL_PGM rises to the program voltage VPGM. Thereafter, when the voltage level of the program wordline WL_PGM rises to the program voltage VPGM, the channel voltage level of the first test transistor TTR1 may be boosted to a level similar to the program voltage VPGM by a capacitive coupling between the channel and the gate terminal of the first test transistor TTR1. For example, as the voltage level of the program wordline WL_PGM rises to the program voltage VPGM, the voltage levels of the first pulling node NP1 and the middle node NM may also rise (i.e., boost) to a level similar to the program voltage VPGM. In this case, because the voltage level difference between the channel and gate of the first test transistor TTR1 may be reduced, a phenomenon in which the first test transistor TTR1 being unintentionally programmed (for example, a phenomenon in which the gate oxide layer of the first test transistor TTR1 being unintentionally broken down) may be prevented.

The first test transistor TTR1 may be produced by the same process (e.g., gate-all-around (GAA) process) as the plurality of cell transistors CTR included in the memory cell array 110. Accordingly, producing the gate oxide thickness of the first test transistor TTR1 different from the gate oxide thickness of the plurality of cell transistors CTR included in the memory cell array 110 may induce a very high process difficulty and a process cost. In this regard, when the gate oxide thickness of the first test transistor TTR1 corresponds to (for example, is substantially the same as) the gate oxide thickness of the plurality of cell transistors CTR included in the memory cell array 110, the process difficulty and process cost of the memory device 100 may be minimized.

According to an embodiment, the gate oxide thickness of the first test transistor TTR1 corresponds to (for example, is substantially the same as) the gate oxide thickness of the plurality of cell transistors CTR included in the memory cell array 110. According to an embodiment, even though the gate oxide thickness of the first test transistor TTR1 is not thicker than the gate oxide thickness of the plurality of cell transistors CTR included in the memory cell array 110, the phenomenon of the gate oxide of the first test transistor TTR1 being broken down by the program voltage VPGM may be prevented. Therefore, according to embodiments, the complexity of the process for producing the memory device 100 may be reduced, and the production cost of the memory device 100 may be reduced.

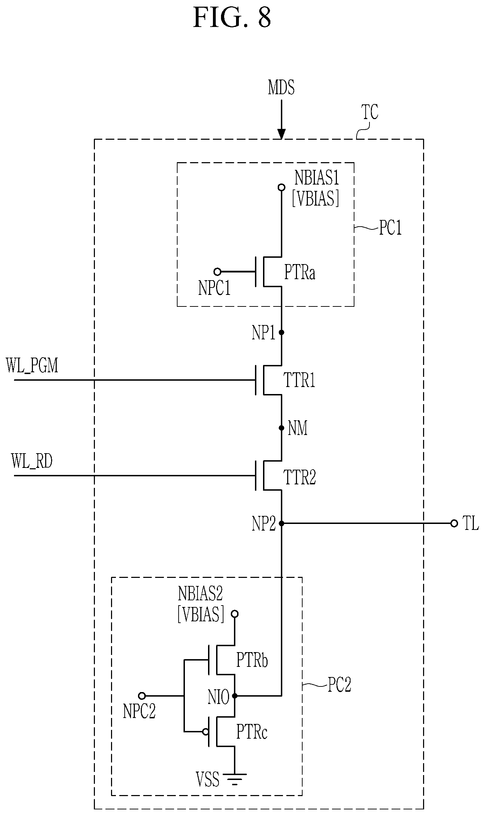

FIG. 8 is a detailed configuration of test circuit according to an embodiment. Hereinafter, with reference to FIGS. 1 to 8, specific implementation methods of the first pulling circuit PC1 and the second pulling circuit PC2 will be exemplarily described. However, embodiments are not limited thereto. For example, one or both of the first pulling circuit PC1 and the second pulling circuit PC2 may be implemented in a manner different from that illustrated in FIG. 8.

The first pulling circuit PC1 may include a first pulling transistor PTRa. The first pulling transistor PTRa may be connected between a first bias node NBIAS1 and the first pulling node NP1. A gate terminal of the first pulling transistor PTRa may be connected to the first pulling control node NPC1. The first bias node NBIAS1 may receive a bias voltage VBIAS.

When the mode selection signal MDS indicates the test mode MD_TST, the first pulling transistor PTRa may provide a test logic high voltage H_TST to the first pulling node NP1. For example, in response to the mode selection signal MDS indicating the test mode MD_TST, the voltage levels of the first bias node NBIAS1 and the first pulling control node NPC1 may transition to a voltage level, which may turn on the first pulling transistor PTRa. In this case, the test logic high voltage H_TST corresponding to the voltage level of the first bias node NBIAS1 (e.g., the bias voltage VBIAS) may be provided to the first pulling node NP1.

On the other hand, when the mode selection signal MDS indicates the program protection mode MD_PT, the first pulling transistor PTRa may electrically float the first pulling node NP1. That is, the first pulling transistor PTRa may electrically isolate the first pulling node NP1 from the first bias node NBIAS1. For example, the voltage levels of the first bias node NBIAS1 and the first pulling control node NPC1 may transition to a voltage level, which may turn off the first pulling transistor PTRa.

In an embodiment, the first pulling transistor PTRa may be implemented as an n-type channel metal oxide semiconductor field effect transistor (NMOS transistor). In this case, the first pulling node NP1 may be electrically isolated more efficiently than when the first pulling transistor PTRa is implemented as a p-type channel metal oxide semiconductor field effect transistor (PMOS transistor). However, embodiments are not limited to a specific implementation method of the first pulling transistor PTRa.

In an embodiment, the bias voltage VBIAS may vary depending on the mode selection signal MDS. For example, the bias voltage VBIAS when the mode selection signal MDS indicates the program protection mode MD_PT may be higher than the bias voltage VBIAS when the mode selection signal MDS indicates the test mode MD_TST. For example, the bias voltage VBIAS when the mode selection signal MDS indicates the program protection mode MD_PT may be about 1.2 V, and the bias voltage VBIAS when the mode selection signal MDS indicates the test mode MD_TST may be about 0.9 V. However, embodiments are not limited thereto.

In an embodiment, when the mode selection signal MDS indicates the test mode MD_TST, the voltage levels of the first bias node NBIAS1 and the first pulling control node NPC1 may be determined as voltage levels, which makes the first pulling transistor PTRa be turned on together when the first and second test transistors TTR1 and TTR2 are turned on. For example, when the mode selection signal MDS indicates the test mode MD_TST, the voltage levels of the first bias node NBIAS1 and the first pulling control node NPC1 may be 0.9 V. However, embodiments are not limited to specific voltage levels of the first bias node NBIAS1 and the first pulling control node NPC1 when the mode selection signal MDS indicates the test mode MD_TST.

In an embodiment, when the mode selection signal MDS indicates the program protection mode MD_PT, the voltage levels of the first bias node NBIAS1 and the first pulling control node NPC1 may be determined as voltage levels that makes the first pulling transistor PTRa be turned off. For example, when the mode selection signal MDS indicates the program protection mode MD_PT, the voltage levels of the first bias node NBIAS1 and the first pulling control node NPC1 may be 1.2 V. However, embodiments are not limited to specific voltage levels of the first bias node NBIAS1 and the first pulling control node NPC1 when the mode selection signal MDS indicates the program protection mode MD_PT. For example, when indicating the program protection mode MD_PT, the voltage level of the first bias node NBIAS1 may be determined as a voltage level higher than the voltage level of the first pulling control node NPC1.

The second pulling circuit PC2 may be configured to output a bias voltage VBIAS or the ground voltage VSS (e.g., a test logic low voltage L_TST) depending on the mode selection signal MDS. For a more concise explanation, an embodiment in which the second pulling circuit PC2 is implemented as an inverter that outputs a bias voltage VBIAS or the ground voltage VSS is described below representatively. However, embodiments are not limited to a specific implementation method of the second pulling circuit PC2. For example, the second pulling circuit PC2 may be implemented as any type of electronic circuit that may provide different voltage levels to the second pulling node NP2 according to a mode selection signal MDS, such as a NAND gate, a power gate, etc.

The second pulling circuit PC2 may include a second pulling transistor PTRb and a third pulling transistor PTRc. The second pulling transistor PTRb may be connected between a second bias node NBIAS2 and an inverter output node NIO, and the third pulling transistor PTRc may be connected between the ground voltage VSS and the inverter output node NIO. The second bias node NBIAS2 may receive a bias voltage VBIAS. The gate terminals of the second pulling transistor PTRb and the third pulling transistor PTRc may be connected to the second pulling control node NPC2. The inverter output node NIO may be connected to the second pulling node NP2.

The voltage level of the second pulling control node NPC2 may vary depending on the mode selection signal MDS. For example, when the mode selection signal MDS indicates the test mode MD_TST, the voltage level of the second pulling control node NPC2 may be logic low. In this case, the test logic low voltage L_TST corresponding to the ground voltage VSS may be provided to the second pulling node NP2.

On the other hand, when the mode selection signal MDS indicates the program protection mode MD_PT, the voltage level of the second pulling control node NPC2 may be logic high. In this case, a voltage corresponding to the bias voltage VBIAS may be provided to the second pulling node NP2, and the second test transistor TTR2 may be turned off.

In an embodiment, the voltage level of the second bias node NBIAS2 may be determined as a voltage level that makes the second test transistor TTR2 be turned off when the program operation being performed on a memory cell row connected to the test circuit TC. For example, the bias voltage VBIAS provided to the second bias node NBIAS2 may be implemented at the same voltage level as the pass voltage VPASS. However, embodiments are not limited thereto.

For a more concise explanation, an embodiment in which a bias voltage VBIAS is provided to the first bias node NBIAS1 and the second bias node NBIAS2 is described in FIG. 8, but embodiments are not limited thereto. For example, different levels of bias voltage VBIAS may be provided to the first bias node NBIAS1 and the second bias node NBIAS2.

In an embodiment, the voltage levels of the first bias node NBIAS1 and the first pulling control node NPC1 may be controlled based on logic circuits such as an inverter, a NAND gate, and the like. For example, the first bias node NBIAS1 and/or the first pulling control node NPC1 may be connected to an output terminal of an inverter that outputs a bias voltage VBIAS. Similarly, the voltage level of the second bias node NBIAS2 and/or the second pulling control node NPC2 may also be controlled based on the logic circuit. That is, embodiments are not limited to a specific manner in which voltage is provided to the first bias node NBIAS1, the second bias node NBIAS2, the first pulling control node NPC1, and the second pulling control node NPC2.

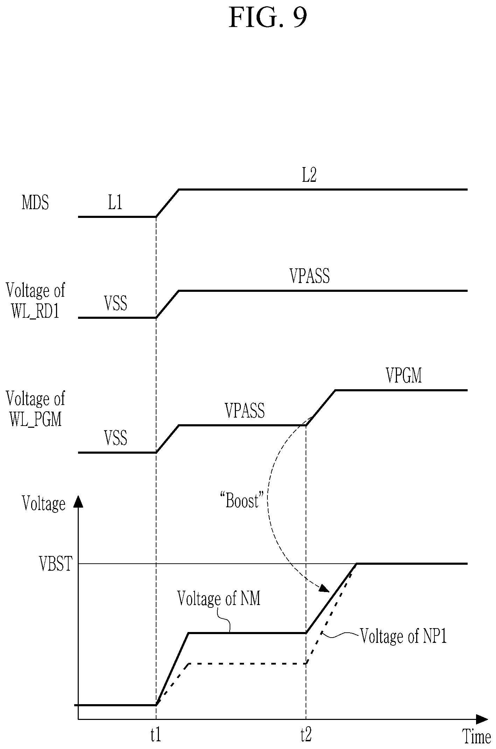

FIG. 9 is a timing diagram showing a program protection operation according to an embodiment. The horizontal axis of FIG. 9 may represent time, and the vertical axis may represent voltage level. Hereinafter, the operation of a test circuit connected to a program target memory cell row will be described with reference to FIGS. 1 to 9.

At the first time point t1, the control logic circuit 120 may control the voltage level of the program wordline WL_PGM and the read wordline WL_RD to increase from the ground voltage VSS to the pass voltage VPASS, by controlling the row decoder 130. For a more concise explanation, it is assumed below that the voltage levels of the program wordline WL_PGM and the read wordline WL_RD are the ground voltage VSS before the first time point t1. However, embodiments are not limited thereto.

At the second time point t2, the control logic circuit 120 may control the row decoder 130 to increase the voltage level of the program wordline WL_PGM to the program voltage VPGM. That is, the control logic circuit 120 may gradually increase the voltage level of the program wordline WL_PGM to the program voltage VPGM through the pass voltage VPASS. However, embodiments are not limited thereto. For example, embodiments are not limited to the voltage level of the program wordline WL_PGM between the first time point t1 and the second time point t2. In this regard, according to an embodiment, the voltage level of the program wordline WL_PGM between the first time point t1 and the second time point t2 may not be the pass voltage VPASS.

Before the second time point t2, the control logic circuit 120 may set the test circuit TC sharing the program target memory cell row and the program wordline WL_PGM to the program protection mode MD_PT. For example, at the first time point t1, the control logic circuit 120 may change the mode selection signal MDS from a first logic level L1 (e.g., a logic level indicating a test mode MD_TST) to a second logic level L2 (e.g., a logic level indicating a program protection mode MD_PT).

For a more concise explanation, it is assumed below that the control logic circuit 120 changes the mode selection signal MDS to a logic level indicating the program protection mode MD_PT at the first time point t1. However, embodiments are not limited to the specific time point at which the control logic circuit 120 changes the logic level of the mode selection signal MDS. For example, the control logic circuit 120 may change the mode selection signal MDS to the second logic level L2 at any time point before the second time point t2, such as before the first time point t1 or during a time period between the first time point t1 and the second time point t2.

In response to the mode selection signal MDS transitioning to the second logic level L2, the test circuit TC may perform the program protection operation. For example, the first pulling circuit PC1 may electrically isolate the first pulling node NP1 from the first bias node NBIAS1 by turning off the first pulling transistor PTRa; and the second pulling circuit PC2 may provide a bias voltage VBIAS to the second pulling node NP2 by turning off the second test transistor TTR2. In this case, the channel of the first test transistor TTR1 (e.g., the first pulling node NP1 and the middle node NM) may be electrically floated.

In an embodiment, between the first time point t1 and the second time point t2, the voltage levels of the middle node NM and the first pulling node NP1 may temporarily increase based on the bias voltage VBIAS provided from the second pulling circuit PC2. However, embodiments are not limited to specific voltage levels of the middle node NM and the first pulling node NP1 between the first time point t1 and the second time point t2.

After the channel of the first test transistor TTR1 is electrically floated, the voltage level of the program wordline WL_PGM may be increased to the program voltage VPGM. In this case, the voltage level of the channel of the first test transistor TTR1 may also be increased with a self-boost scheme. For example, after the second time point t2, the voltage levels of the first pulling node NP1 and the middle node NM may rise to a boost voltage VBST corresponding to the program voltage VPGM. In this case, the difference between the program voltage VPGM and the boost voltage VBST may be prevented from becoming large enough to break down the gate oxide layer of the first test transistor TTR1. Therefore, according to an embodiment, even if the voltage level of the program wordline WL_PGM rises to the program voltage VPGM, a phenomenon in which the first test transistor TTR1 is unintentionally programmed may be prevented.

In an embodiment, the boost voltage VBST may be about 80% of the program voltage VPGM. However, embodiments are not limited to a specific level of the boost voltage VBST.

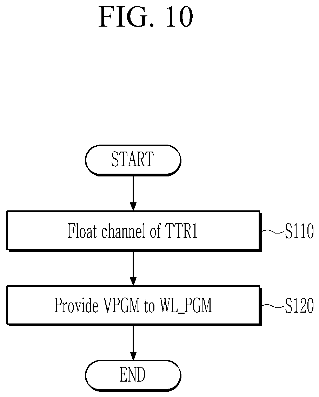

FIG. 10 is a flowchart showing an operation method of a memory device according to an embodiment. Hereinafter, with reference to FIGS. 1 to 10, an operation method of the memory device 100 performing a program protection operation for a test circuit TC which shares a program wordline WL_PGM with a program target memory cell row is described.

At operation S110, the memory device 100 may float a channel of the first test transistor TTR1 included in a test circuit TC which shares a program wordline WL_PGM with the program target memory cell row. For example, the control logic circuit 120 may provide a mode selection signal MDS indicating a program protection mode MD_PT to the corresponding test circuit TC. In this case, the test circuit TC may float the channel of the first test transistor TTR1 in response to the mode selection signal MDS.

In an embodiment, the test circuit TC, which shares a program wordline WL_PGM with a program target memory cell row, may be referred to as a 'program protection target test circuit'. However, embodiments are not limited to such term.

In an embodiment, the first test transistor TTR1 included in the 'program protection target test circuit' may also be referred to as a 'program protection target test transistor' or 'program protection test transistor'. However, embodiments are not limited to such terms.

At operation S120, the memory device 100 may provide a program voltage VPGM to a program wordline WL_PGM. For example, after the channel of the first test transistor TTR1 is floated, the control logic circuit 120 may control the row decoder 130 to increase the voltage level of the program wordline WL_PGM connected to the program target memory cell row to the program voltage VPGM. In this case, even if the voltage level of the program wordline WL_PGM rises, the gate oxide layer of the 'program protection target test transistor' may be protected based on a self-boosting scheme.

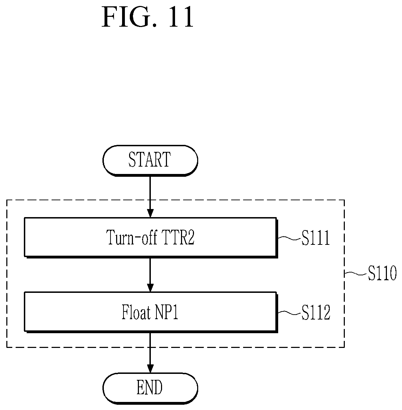

FIG. 11 is a drawing showing operation S110 of FIG. 10 in more detail. Referring to FIGS. 1 to 11, at operation S111, the test circuit TC may turn off the second test transistor TTR2. For example, the second pulling circuit PC2 may turn off the second test transistor TTR2 by providing a bias voltage VBIAS to the second pulling node NP2. In this case, the middle node NM may be electrically isolated from the second pulling node NP2.

At operation S112, the test circuit TC may float the first pulling node NP1. For example, the first pulling circuit PC1 may turn off the first pulling transistor PTRa in response to the mode selection signal MDS. In this case, the first pulling node NP1 may be electrically floated.

For a more concise explanation, FIG. 11 illustrates that operation S112 is performed after operation S111, but embodiments are not limited to the specific order in which operations S111 and S112 are performed. For example, the test circuit TC may turn off the second test transistor TTR2 after turning off the first pulling transistor PTRa, or may turn off the first pulling transistor PTRa and the second test transistor TTR2 substantially simultaneously.

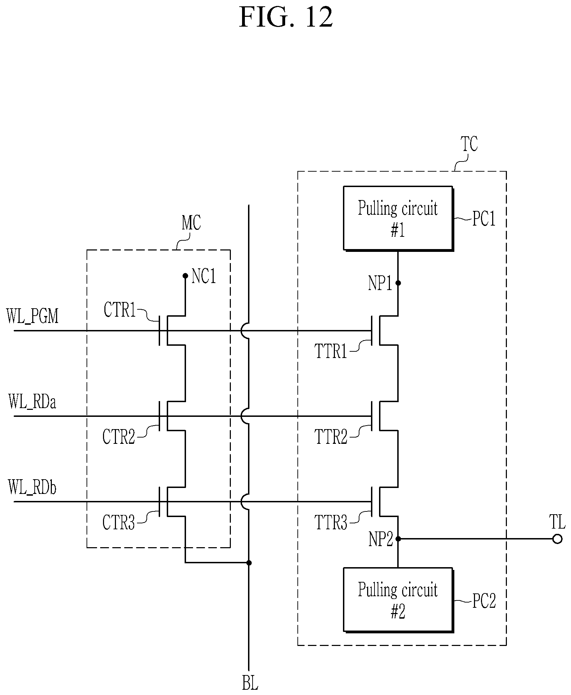

FIG. 12 is a drawing showing a portion of a memory device according to an embodiment in more detail. Referring to FIGS. 1 to 12, each memory cell MC of the memory cell array 110 may include three cell transistors CTR. For example, each memory cell MC of the memory cell array 110 may include first to third cell transistors CTR1 to CTR3.

The first to third cell transistors CTR1 to CTR3 may be connected in series between the first cell node NC1 and the bitline BL. A gate terminal of the first cell transistor CTR1 may be connected to the program wordline WL_PGM, and gate terminals of the second and third cell transistors CTR2 to CTR3 may be connected to the first and second read wordlines WL_RDa and WL_RDb, respectively.

The first cell transistor CTR1 may be programmed based on the voltage level of the program wordline WL_PGM. The second and third cell transistors CTR2 and CTR3 may be turned on or turned off based on the voltage levels of the first and second read wordlines WL_RDa and WL_RDb, respectively.

Each test circuit TC of the test circuit array 140 may include three test transistors TTR. For example, the test circuit TC may include first to third test transistors TTR1 to TTR3.

The first to third test transistors TTR1 to TTR3 may be connected in series between the first pulling node NP1 and the second pulling node NP2. A gate terminal of the first test transistor TTR1 may be connected to the program wordline WL_PGM, and gate terminals of the second and third test transistors TTR2 to TTR3 may be connected to the first and second read wordlines WL_RDa and WL_RDb, respectively. The first to third test transistors TTR1 to TTR3 may operate based on the operation levels of the program wordline WL_PGM and the first and second read wordlines WL_RDa and WL_RDb, respectively.

That is, the test circuit TC may include a number of test transistors TTR corresponding to the number of cell transistors CTR included in each memory cell MC.

FIG. 12 illustrates an example in which a memory cell MC includes three transistors, but embodiments are not limited thereto. For example, each memory cell MC may also be implemented to include four or more cell transistors CTR connected between the first cell node NC1 and the bitline BL. In this case, the test circuit TC may also include four or more test transistors TTR.

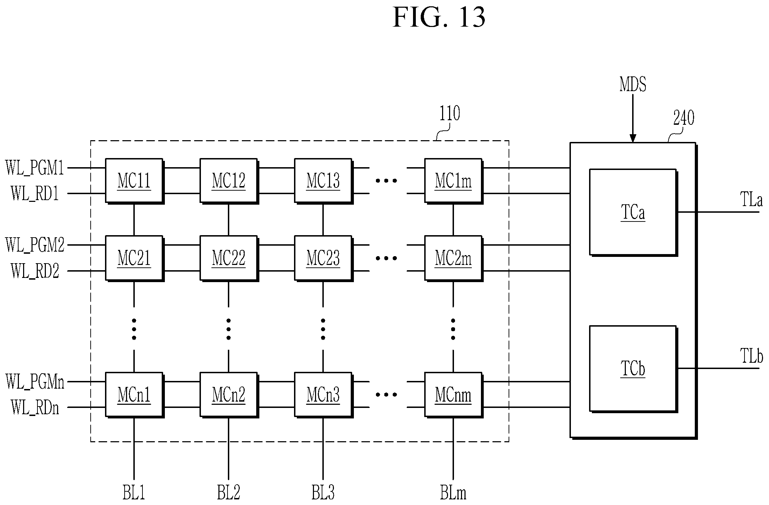

FIG. 13 is a block diagram showing the configuration of a test circuit array according to an embodiment. Referring to FIG. 1 and FIG. 13, the memory cell array 110 may include a plurality of memory cells MC. The plurality of memory cells MC may be connected to first to n-th program wordlines WL_PGM1 to WL_PGMn and first to n-th read wordlines WL_RD1 to WL_RDn. The configuration of the memory cell array 110 is similar to that described above with reference to FIG. 2, so a detailed description is omitted.

The test circuit array 240 may include a first test circuit TCa and a second test circuit TCb.

Each of the first test circuit TCa and the second test circuit TCb may be connected to a plurality of program wordlines WL_PGM and a plurality of read wordlines WL_RD. For example, the first test circuit TCa may be connected to odd-numbered program wordlines (e.g., the first program wordline WL_PGM1, the third program wordline WL_PGM3, etc.) and odd-numbered read wordlines (e.g., the first read wordline WL_RD1, the third read wordline WL_RD3, etc.); and the second test circuit TCb may be connected to even-numbered program wordlines (e.g., the second program wordline WL_PGM2, the fourth program wordline WL_PGM4, etc.) and even-numbered read wordlines (e.g., the second read wordline WL_RD2, the fourth read wordline WL_RD4, etc.). However, embodiments are not limited thereto.

In contrast to the test circuit array 140 described above with reference to FIG. 2, each of the test circuits TC included in the test circuit array 240 may be connected to a plurality of pairs of wordlines. For example, each of the test circuits TC included in the test circuit array 240 may correspond to a plurality of memory cell rows.

The first test circuit TCa may be connected to the first test line TLa. The first test circuit TCa may control the voltage level of the first test line TLa based on one of a plurality of pairs of wordlines connected to the first test circuit TCa. For example, the control logic circuit 120 may test whether the row decoder 130 may normally drive the first program wordline WL_PGM1 and the first read wordline WL_RD1. In this case, the first test circuit TCa may control the voltage level of the first test line TLa based on the voltage levels of the first program wordline WL_PGM1 and the first read wordline WL_RD1.

Similarly, a second test circuit TCb may be connected to a second test line TLb. The second test circuit TCb may control the voltage level of the second test line TLb based on one of a plurality of pairs of wordlines connected to the second test circuit TCb.

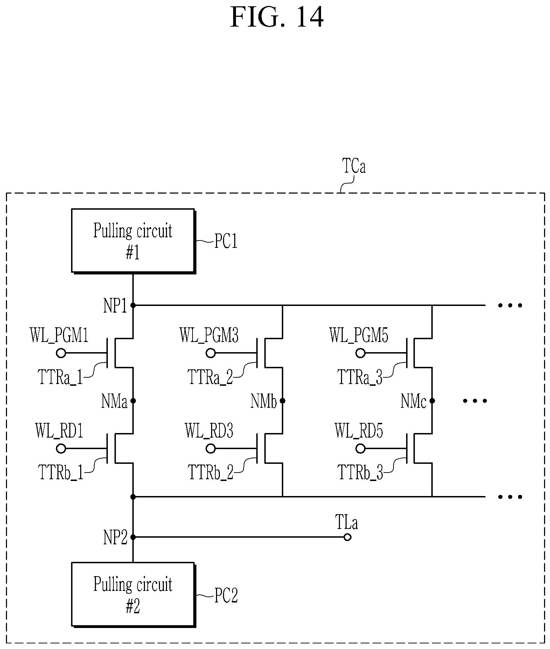

FIG. 14 is a drawing showing the configuration of the test circuit of FIG. 13 in more detail. Hereinafter, configuration of the first test circuit TCa will be exemplarily described with reference to FIG. 1 and FIGS. 13 to 14. However, embodiments are not limited thereto.

The first test circuit TCa may include the first pulling circuit PC1, the second pulling circuit PC2, a first plurality of test transistors TTRa, and a second plurality of test transistors TTRb. The first pulling circuit PC1 may be connected to a first pulling node NP1, and a second pulling circuit PC2 may be connected to a second pulling node NP2. The first test line TLa may be connected to the second pulling node NP2. The configuration and operation of the first pulling circuit PC1 and the second pulling circuit PC2 are similar to those described above with reference to FIGS. 1 to 12, so a detailed description is omitted.

The first plurality of test transistors TTRa may be connected between the first pulling node NP1 and a plurality of middle nodes NM, respectively. Gate terminals of the first plurality of test transistors TTRa may be respectively connected to odd-numbered program wordlines. For example, the test transistor TTRa_1 may be connected between the first pulling node NP1 and a middle node NMa, and a gate terminal of the test transistor TTRa_1 may be connected to the first program wordline WL_PGM1.

The second plurality of test transistors TTRb may be connected between the second pulling node NP2 and the plurality of middle nodes NM, respectively. Gate terminals of the second plurality of test transistors TTRb may be respectively connected to even-numbered program wordlines. For example, the test transistor TTRb_1 may be connected between the second pulling node NP2 and the middle node NMa, and the gate terminal of the test transistor TTRb_1 may be connected to the first read wordline WL_RD1.

The control logic circuit 120 may test, based on the first test circuit TCa, whether the row decoder 130 normally controls a pair of wordlines connected to the first test circuit TCa. For example, the control logic circuit 120 may test whether the row decoder 130 may normally drive the first program wordline WL_PGM1 and the first read wordline WL_RD1. In this case, the control logic circuit 120 may determine the voltage levels of the first program wordline WL_PGM1 and the first read wordline WL_RD1 in a manner similar to that described above with reference to FIG. 3; and may provide a turn-off voltage (e.g., ground voltage VSS) to other wordlines connected to the first test circuit TCa (e.g., the third program wordline WL_PGM3, the third read wordline WL_RD3, etc.). In this case, the first test circuit TCa may determine the voltage level of the first test line TLa based on the voltage levels of the first program wordline WL_PGM1 and the first read wordline WL_RD1. In this way, the control logic circuit 120 may sequentially test whether the row decoder 130 normally controls a pair of wordlines connected to the first test circuit TCa.

## Claims

1. A test circuit (TC) connected to a program wordline (WL_PGM) and a read wordline (WL_RD) of an anti-fuse memory device (100), the test circuit (TC) comprising:
a first pulling circuit (PC1) connected to a first pulling node (NP1), wherein the first pulling circuit (PC1) is configured to electrically float the first pulling node (NP1) based on a mode selection signal (MDS);
a first test transistor (TTR1) connected between the first pulling node (NP1) and a middle node (NM), wherein a first gate terminal of the first test transistor (TTR1) is connected to the program wordline (WL_PGM);
a second test transistor (TTR2) connected between the middle node (NM) and a second pulling node (NP2), wherein a second gate terminal of the second test transistor (TTR2) is connected to the read wordline (WL_RD); and
a second pulling circuit (PC2) connected to the second pulling node (NP2).

2. The test circuit (TC) of claim 1, wherein between a second time point (t2) and a third time point:
a program operation is performed on a memory cell row (MC11 - MC1m) connected to the program wordline (WL_PGM) and the read wordline (WL_RD),
a voltage level of the program wordline (WL_PGM) is a program voltage (VPGM), and
a voltage level of the read wordline (WL_RD) is a pass voltage (VPASS) lower than the program voltage, and
wherein the first pulling circuit (PC1) is configured to electrically float the first pulling node (NP1), based on the mode selection signal (MDS) indicating a program protection mode (MD_PT) at a first time point (t1) prior to the second time point (t2).

3. The test circuit (TC) of claim 1 or 2, wherein the first pulling circuit (PC1) comprises a pulling transistor (PTRa), which is connected between a bias node (NBIAS1) and the first pulling node (NP1), and is configured to operate based on a voltage level of a pulling control node (NPC1), and
wherein the voltage level of the pulling control node (NPC1) is determined based on the mode selection signal (MDS).

4. The test circuit (TC) of claim 3, wherein the pulling transistor (PTRa) is turned off at the first time point (t1) based on the voltage level of the pulling control node (NPC1) and a voltage level of the bias node (NBIAS1).

5. The test circuit (TC) of claim 3 or 4, wherein between the first time point (t1) and the third time point, the voltage level of the bias node (NBIAS1) is equal to or higher than the voltage level of the pulling control node (NPC1).

6. The test circuit (TC) of any one of claims 1 to 5, wherein the second pulling circuit (PC2) is configured to turn off the second test transistor (TTR2) by providing a bias voltage (VBIAS) higher than a ground voltage (VSS) to the second pulling node (NP2), based on the mode selection signal (MDS) indicating the program protection mode.

7. The test circuit (TC) of claim 6, wherein the second pulling circuit (PC2) comprises an inverter (PTRb and PTRc) configured to selectively output one of the bias voltage (VBIAS) and the ground voltage (VSS) based on the mode selection signal (MDS).

8. The test circuit (TC) of any one of claims 1 to 7, wherein between the second time point (t2) and the third time point, voltage levels of the first pulling node (NP1) and the middle node (NM) are boosted based on the program voltage.

9. The test circuit (TC) of any one of claims 1 to 8, wherein a first thickness of a first gate oxide layer of the first test transistor (TTR1) corresponds to a second thickness of a second gate oxide layer of a transistor of a memory cell (MC) in the anti-fuse memory device (100).

10. The test circuit (TC) of any one of claims 1 to 8, wherein the mode selection signal (MDS) indicates a test mode (MD_TST) between a fourth time point and a fifth time point,
wherein the first pulling circuit (PC1) is configured to provide a test logic high voltage (H_TST) to the first pulling node (NP1) between the fourth time point and the fifth time point, and
wherein the second pulling circuit (PC2) is configured to provide a test logic low voltage (L_TST) to the second pulling node (NP2) between the fourth time point and the fifth time point.

11. A memory device (100) comprising:
a row decoder (130) configured to control a program wordline (WL_PGM1) and a read wordline (WL_RD1);
a memory cell array (110) comprising an anti-fuse memory cell row (MC11 - MC1m) which is connected to the program wordline (WL_PGM1) and the read wordline (WL_RD1); and
a test circuit (TC1) comprising:
a first test transistor (TTR1) comprising a first gate terminal connected to the program wordline (WL_PGM1); and
a second test transistor (TTR2) comprising a second gate terminal connected to the read wordline (WL_RD1),
wherein the test circuit is configured to float a channel of the first test transistor (TTR1) during a time period (after t2) and a program operation is performed on the anti-fuse memory cell row (MC11 - MC1m) during the time period (after t2).

12. The memory device of claim 11, wherein the first test transistor (TTR1) is connected between a first pulling node (NP1) and a first middle node (NM),
wherein the second test transistor (TTR2) is connected between the first middle node (NM) and a second pulling node (NP2), and
wherein the test circuit is configured to float the first pulling node (NP1) and the first middle node (NM) during the time period (after t2).

13. The memory device of claim 11 or 12, further comprising:
a first pulling circuit (PC1) connected to the first pulling node (NP1), wherein the first pulling circuit (PC1) is configured to electrically float the first pulling node (NP1) during the time period (after t2); and
a second pulling circuit (PC2) connected to the second pulling node (NP2), wherein the second pulling circuit (PC2) is configured to turn off the second test transistor (TTR2) by providing a bias voltage (VBIAS) to the second pulling node (NP2) during the time period (after t2).

14. An operation method of a memory device (100) including a plurality of anti-fuse memory cells (MC) connected to a program wordline (WL_PGM), the operation method comprising:
floating (S110) a channel of a first test transistor (TTR1) connected between a first node (NP1) and a second node (NM), wherein a first gate terminal of the first test transistor (TTR1) is connected to the program wordline (WL_PGM); and
providing (S120) a program voltage (VPGM) to the program wordline (WL_PGM).

15. The operation method of claim 14, wherein the floating comprises:
turning off (S111) a second test transistor (TTR2) connected between the second node (NM) and a third node (NP2), wherein a second gate terminal of the second test transistor (TTR2) is connected to a read wordline (WL_RD1) corresponding to the program wordline (WL_PGM); and
floating (S112) the first node (NP1).
